(19) Europäisches Patentamt / European Patent Office / Office européen des brevets

(11) **EP 1 783 912 B1**

(12) **EUROPÄISCHE PATENTSCHRIFT**

(45) Veröffentlichungstag und Bekanntmachung des Hinweises auf die Patenterteilung:
**12.11.2008 Patentblatt 2008/46**

(51) Int Cl.:
*H03K 19/09* *(2006.01)*    *H03K 19/21* *(2006.01)*
*H01H 47/00* *(2006.01)*

(21) Anmeldenummer: **06022283.3**

(22) Anmeldetag: **25.10.2006**

(54) **Einkanalige sichere Schaltung für den Ausgang eines Bus-Teilnehmers**

Single-channel secure circuit for the output of a bus device

Circuit protégé à canal unique pour la sortie d'un utilisateur de bus

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **02.11.2005 DE 102005052579**

(43) Veröffentlichungstag der Anmeldung:
**09.05.2007 Patentblatt 2007/19**

(73) Patentinhaber: **Phoenix Contact GmbH & Co. KG 32825 Blomberg (DE)**

(72) Erfinder:
• **Oster, Viktor
  32825 Blomberg (DE)**
• **Landwehr, Heinz-Carsten
  32657 Lemgo (DE)**

(74) Vertreter: **Kampfenkel, Klaus
  Blumbach - Zinngrebe
  Patentanwälte
  Alexandrastrasse 5
  65187 Wiesbaden (DE)**

(56) Entgegenhaltungen:
**EP-A2- 0 094 238      JP-A- 4 344 394**

**Beschreibung**

Die Erfindung betrifft eine Ausgangsschaltung mit einkanaligem Peripherieanschluss für eine Bus-Ausgangsbaugruppe zum Schalten einer an den Peripherieanschluss angeschlossenen induktiven Last.

Häufig wird man beim Einsatz von Ausgangsschaltungen, welche zum Schalten von angeschlossenen induktiven Lasten, z.B. Relais oder Schütze, verwendet werden, mit Problemen des Zusammenwirkens zwischen den induktiven Lasten und den in der Ausgangsschaltung eingesetzten Treiberbausteinen konfrontiert. Da die in den Lasten gespeicherte Energie beim Abschalten der Treiberbausteine herkömmlicherweise zu einer induktiven Schaltenergie führt, welche die Überlastung des Treiberbausteins zur Folge haben kann und diesen folglich auch zerstören kann, schreiben Hersteller üblicherweise eine externe Schutzbeschaltung vor, in welcher die in der Last abgespeicherte Energie umgesetzt werden soll.

Andernfalls würde beispielsweise im Falle eines überlasteten Ausgangstreiberbausteins, dessen interne Temperaturüberwachung bei Überhitzung anspricht und den Treiberbaustein abschaltet, das Abschalten dazu führen, dass die induktive Abschaltenergie der Last zusätzlich im Treiber umgesetzt wird, welches zur Zerstörung des Treibers führt.

Die vorgegebenen Schutzbeschaltungen sollen die hierbei auftretenden negativen Abschaltspannungen auf einen Wert begrenzen, bei dem der Treiberbaustein nicht mehr belastet bzw. lediglich innerhalb unkritischer Grenzen belastet wird.

Die maximale Spannung der Schutzbeschaltung $U_{MAX}$ darf in diesem Fall folgenden Wert nicht überschreiten:

$$U_{MAX} <= U_T - U_V, \qquad\qquad (1)$$

wobei $U_T$ die maximale Spannung der parasitären Diode des Ausgangstreiberbausteins ist, typischer Weise etwa 45 Volt, und $U_V$ die Versorgungsspannung.

Bei einer Versorgungsspannung $U_V$ von 30 Volt ergibt sich somit eine Spannungsbegrenzung von $U_{MAX}$ von maximal 15 Volt.

Da diese Spannungsbegrenzung jedoch äußerst gering ist, führt dies dazu, dass die Abfallzeiten der angeschlossenen Lasten häufig wesentlich verlängert werden.

Diese verlängerten Abfallzeiten führen wiederum zu einem langsamen Abfallen der Kontakte einer Last beim Abschalten und infolge ggf. zu einem Verbrennen der Kontakte und zu einer Verkürzung der Lebensdauer der Last, wie beispielsweise von Schützen oder Relais. Aufgrund verzögerter Abfallzeiten ist darüber hinaus insbesondere bei sicherheitskritischen Prozessen oftmals ein verspätetes Abschalten der Last als weitere negative Folge zu verzeichnen. Insbesondere im Falle einer zu geringen Spannungsbegrenzung, wie z.B. bei voraufgezeigten maximal 15 Volt, ist es ferner häufig schwierig bis unmöglich eine externe Schutzbeschaltung überhaupt zu realisieren oder ist häufig lediglich eine minimale Wirkung einer in der Last vorhanden externen Schutzbeschaltung gegeben. Darüber hinaus fließt während des Abschaltvorgangs der Strom über die Versorgungsquelle, so dass die Gesamtenergie, die in der Schutzbeschaltung umgesetzt wird, fast um den Faktor 2 höher ist als die in der Last abgespeicherte Energie, so dass die Schutzbauelemente überdimensioniert werden müssen, was sich wiederum im Preis widerspiegelt.

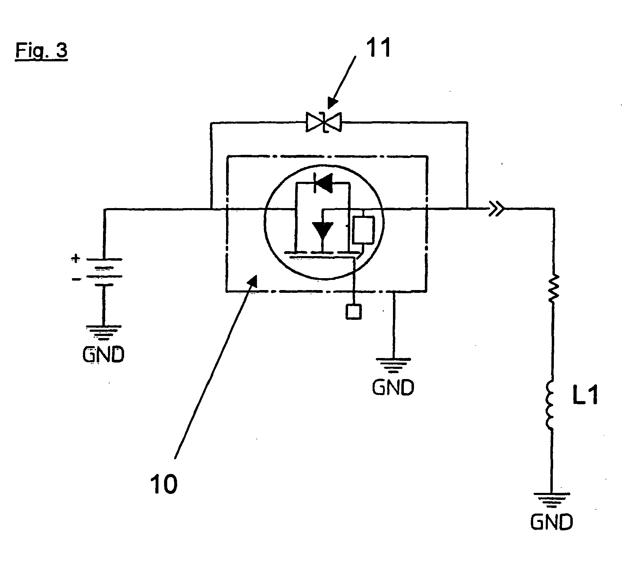

Fig. 3 zeigt eine bekannte Lösung, die insbesondere von Halbleiterherstellern vorgeschlagen wird, gemäß welcher ein Ausgangstreiberbaustein 10 mit einer parallel angeschlossenen Suppressordiode 11 geschützt wird. Damit die Suppressordiode 11 den Treiberbaustein 10 von der induktiven Abschaltenergie der angeschlossenen Last L1 entlastet, muss jedoch die Zehner-Spannung kleiner als die Reverse-Spannung des Treibers 10 sein, welche typischerweise etwa 45 Volt beträgt. Die gemäß Fig. 3 vorgeschlagene Schaltung entlastet zwar den Treiberbaustein 10 von der induktiven Abschaltenergie, hat darüber hinaus jedoch im Wesentlichen die gleichen voraufgezeigten negativen Eigenschaften und weitere Nachteile.

So wird die Spannungsbegrenzung für die externe Schutzbeschaltung weiter eingeschränkt, da die Vorwärtsspannung der Suppressordiode 11 kleiner sein muss als die Vorwärtsspannung der parasitären Diode des Ausgangstreiberbausteins 10. Ferner neigt die Schutzbeschaltung 11 dazu, beim Ausfall in den Kurzschluss überzugehen, welches wiederum zum Setzen des Ausgangs führt, welches insbesondere für eine Anwendung innerhalb der Sicherheitstechnik ein sehr ungünstiges Verhalten darstellt.

Eine solche Ausgangsschaltung ist auch aus dem EP-A-0 094 238 bekannt.

Aufgabe der Erfindung ist es somit, eine neue und gegenüber dem Stand der Technik wesentlich verbesserte Schaltung zum ausgangsseitigen Schalten einer angeschlossenen induktiven Last aufzuzeigen, welche insbesondere zu einer Begrenzung induktiver Abschaltenergie unmittelbar am Ausgang bzw. am Peripherieanschluss führt.

Die erfindungsgemäße Lösung der Aufgabe ist durch den Gegenstand mit den Merkmalen des Anspruchs 1 gegeben. Vorteilhafte und/oder bevorzugte Ausgestaltungen, Verwendungen, Weiterbildungen und die erfindungsgemäße Schaltung umfassende Busbaugruppen sind Gegenstand der weiteren Ansprüche.

Erfindungsgemäß ist somit vorgesehen, eine Ausgangsschaltung mit einkanaligem Peripherieanschluss für eine Bus-Ausgangsbaugruppe zum Schalten einer an den Peripherieanschluss angeschlossenen induktiven Last mit wenigstens zwei zwischen einer Versorgungsspannung und dem Peripherieanschluss in Reihe geschalteten Treibermodulen auszubilden. Gemäß bevorzugter Ausführungsformen ist die Verwendung von FET-Transistoren vorgeschlagen, wobei auch andere Transistoren einsetzbar sind.

Ein wesentlicher Vorteil hierbei ist, dass aufgrund der Reihenschaltung der Treibermodule diese immer gleichzeitig geschaltet werden und in Folge der aufsummierten Reverse-Spannungen der wenigstens zwei Treibermodule die induktive Abschaltenergie auf den negativen Wert der Versorgungsspannung begrenzt werden kann.

In zweckmäßiger Weiterbildung ist vorgesehen, den Treibermodulen eine Suppressordiode nachzuschalten, vorzugsweise parallel zu einer anschließbaren Last.

In diesem Fall führt der Ausfall der Suppressordiode wiederum zum Kurzschluss, welches jedoch erfindungsgemäß zum Kurzschließen des Ausgangs führt und, da der Ausfall somit in eine sichere Richtung führt, für die Anwendung, insbesondere im Bereich der Sicherheitstechnik, ein vorteilhaftes Verfahren darstellt.

Sind in der Last schon Schutzbauelemente vorhanden, entfalten sie die volle Wirkung und entlasten zusätzlich die Suppressordiode.

Da ferner während des Abschaltvorgangs kein Strom über die Versorgungsquelle fließt, wird in der erfindungsgemäßen Schaltung nur die in der induktiven Last abgespeicherte Energie umgesetzt. Hierdurch ergibt sich eine relativ kleine Belastung der Schutzelemente, also insbesondere der Suppressordiode, so dass die Schaltung insgesamt wesentlich preisgünstiger als nach dem Stand der Technik realisierbar ist.

Ferner werden durch die wenigstens zwei in Reihe geschalteten Treibermodule zwei Abschaltwege bereit gestellt, die wiederum eine erhöhte Sicherheit beim Abschalten der Last bieten, welches ebenfalls für den Einsatz vorteilhaft und insbesondere in der Sicherheitstechnik besonders vorteilhaft ist.

Da bei bevorzugter Verwendung der Suppressordiode die Abschaltenergie direkt am Ausgang und nicht in den Treibermodulen umgesetzt wird, ist darüber hinaus die zulässige Schaltfrequenz wesentlich höher, welches wiederum für einen Einsatz der erfindungsgemäßen Schaltung für Anwendungen von Vorteil ist, bei denen die Ausgangsspannung durch Impuls-Pausen-Verhältnis geregelt wird, wie es beispielsweise bei Analogausgangsschaltungen der Fall ist.

Gemäß weiterer bevorzugter Ausgestaltung ist ferner vorgesehen, jedem der Treibermodule über den einen Peripherieanschluss einen Lastkanal zuzuweisen, so dass die Schaltung auch zum Aufbau von zwei oder mehr Kanälen verwendbar ist, insbesondere in der Sicherheitstechnik, und z. B. die Anforderungen an zwei- und mehrkanalige Systeme nach DIN EN 954-1 erfüllt werden.

Da die Erfindung ferner zu verkürzten Abfallzeiten der Kontakte der Last führt, ist auch die Lebensdauer der Last, wie beispielsweise eines Relais, Schützes oder Motors, wesentlich länger als bei Schaltungen gemäß Stand der Technik. Ein weiterer Vorteil ist, dass durch das schnellere Abschalten der Last wesentlich verbesserte Reaktionszeiten erreicht werden, welches ebenfalls, insbesondere für die Anwendung in der Sicherheitstechnik, besonders vorteilhaft ist.

Da die erfindungsgemäße Schaltung somit insgesamt für weniger abzufangene Energie ausgelegt werden muss, verringern sich folglich die mit der Schaltung verbundenen Kosten. Darüber hinaus erhöhen sich die EMV (elektromagnetischen Verträglichkeits)-Eigenschaften.

In weiterer zweckmäßiger Ausgestaltung ist ferner vorgesehen, den Aufbau der Schaltung auf diskreten Bauteilen basierend zu realisieren. Auch die Integrierung zumindest der Treibermodule innerhalb eines gemeinsamen Bauteils und ggf. die weitere Integrierung der Suppressordiode innerhalb des gemeinsamen Bauteils ist von Vorteil, da eine gemeinsame Ladungspumpe, Übertemperatur- und Überstromüberwachung verwendet werden kann und ein gemeinsames Bauteil einen geringeren Platzbedarf erfordert und kostengünstiger auszulegen ist.

Überdies ist das Testen der erfindungsgemäßen Ausgangsschaltung durch kurzzeitiges Anschalten der Treibermodule jeweils kurz nacheinander und durch Detektierung der jeweiligen Ausgangsspannung besonders einfach und auch für den Einsatz in der Sicherheitstechnik besonders vorteilhaft, da die erfindungsgemäße Schaltung somit durch gezielte Ansteuern der Treibermodule zu 100 % getestet werden kann, ohne dass am Ausgang die Testimpulse sichtbar sind.

Die erfindungsgemäße Schaltung ist somit bevorzugt zum Schalten eines Aktor-Schutzschaltelements verwendbar und/oder innerhalb einer Busausgangsbaugruppe integriert, welche Teil eines Masters, einer sicheren Steuerung und/oder einer Feldeinheit ist.

Die Erfindung wird nachfolgend anhand zweier bevorzugter Ausführungsformen unter Bezugnahme auf die beigefügten Zeichnungen näher beschrieben. In den Zeichnungen zeigen:

Fig. 1    einen diskreten Aufbau der erfindungsgemäßen Ausgangsschaltung,

Fig. 2    einen integrierten Aufbau der erfindungsgemäßen Ausgangsschaltung, und

Fig. 3    eine Schutzbeschaltung nach dem Stand der Technik.

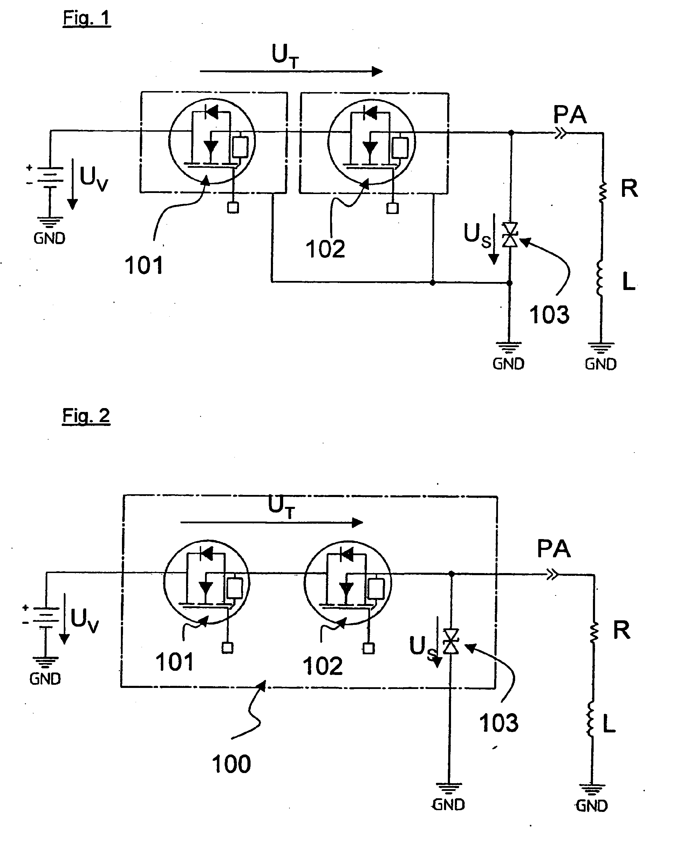

Nachfolgend wird auf die Figuren 1 und 2 Bezug genommen, welche eine erfindungsgemäße Ausgangsschaltung mit einkanaligem Peripherieanschluss "PA" für eine Busausgangsbaugruppe zum Schalten einer an den Peripherieanschluss angeschlossenen induktiven Last unter Einsatz diskreter Bauteile bzw. innerhalb eines gemeinsamen Bauteiles integrierter Komponenten darstellen.

Die Schaltung besteht jeweils aus zwei Ausgangstreibern 101 und 102, die im vorliegenden Fall als FET-Transistoren herausgebildet sind. Die Ausgangstreiber sind in Reihe zwischen dem Peripherieanschluss PA und der Versorgungsspannung $U_V$ geschaltet. Am Ausgang bzw. am Peripherieanschluss ist eine Last L angeschaltet sowie darstellungsgemäß ein Widerstand R als Gesamtwiderstand.

Zum Schutz gegen Überspannung und gegen induktive Abschaltenergie ist mit dem Ausgang ferner eine Suppressordiode 103 mit einer maximalen Spannung von beispielsweise 35 Volt verbunden. Die Suppressordiode 103 ist parallel zur Last geschaltet und schützt die erfindungsgemäße Ausgangsschaltung zusätzlich gegen EMV-Störungen.

In Fig. 2 sind die Ausgangstreibern 101 und 102 und die Suppressordiode 103 innerhalb einem Bauteil 100 integriert dargestellt.

Ist, wie bei Fig. 1 und 2 dargestellt, keine externe Schutzbeschaltung vorhanden, wird die induktive Abschaltenergie lediglich intern in dieser Suppressordiode umgesetzt. Aufgrund der mit den in Reihe geschalteten Ausgangstreibern 101 und 102 realisierten Ausgangsschaltung wird beim Abschalten der induktiven Last L keine Energie in den Ausgangstreibern 101 und 102 umgesetzt wird. Da die Ausgangstreiber 101 und 102 in Reihe geschaltet sind, werden beide gleichzeitig ein- und ausgeschaltet, wobei die maximale Abschaltspannung über beide Ausgangstreiber 101 und 102 beim Abschalten einer induktiven Last sich wie folgt zusammensetzen.

Beträgt die maximale Versorgungsspannung $U_V$ = 30 Volt und die Klemmspannung $U_S$ der Suppressordiode 103 35 Volt, verhält sich die maximale zulässige Spannung $U_T$ über beide Ausgangstreiber wie folgt:

$$U_T > U_V + U_S = 65 \text{ Volt.} \qquad (2)$$

Aufgrund der Reihenschaltung teilt sich jedoch die maximale Spannung über beide Ausgangstreiber 101 und 102 von 65 Volt hälftig auf und belastet somit jeden der Ausgangstreiber mit etwa 33 Volt. Die Spannung der parasitären Zehner-Diode eines jeden Ausgangstreibers 101 bzw. 102 beträgt jedoch typischerweise 45 Volt, so dass diese Zehner-Dioden der Ausgangstreiber nicht leitend werden.

Zum Testen der Ausgangstreiber 101 und 102 werden diese nacheinander kurzzeitig angeschaltet und der Zustand der Ausgangsspannungen zurück gelesen. Dadurch kann eine Diagnose mit hundertprozentiger Fehleraufdeckung der Schaltung realisiert werden. Da ferner die erfindungsgemäße Ausgangsschaltung zwei Abschaltwege mittels der zwei Ausgangstreiber bereit hält, ist darüber hinaus der Aufbau von zweikanaligen Systemen für die Anwendung in der Sicherheitstechnik ermöglicht.

Die erfindungsgemäße Schaltung eignet somit bevorzugt zum Schalten von sicherheitsrelevanten Aktor-Schutzschaltelementen, z.B. in Form von Relais, Schützen oder Motoren und/oder ist innerhalb einer Busausgangsbaugruppe integriert, welche bevorzugt Teil eines Masters, einer sicheren Steuerung und/oder einer Feldeinheit ist.

**Patentansprüche**

1. Ausgangsschaltung mit einkanaligem Peripherieanschluss für eine Bus-Ausgangsbaugruppe zum Schalten einer an den Peripherieanschluss angeschlossenen induktiven Last,
   **gekennzeichnet durch**
   wenigstens zwei zwischen einer Versorgungsspannung ($U_T$) und dem Peripherieanschluss (PA) in Reihe geschaltete Treibermodule (101, 102), insbesondere FET-Transistoren.

2. Ausgangsschaltung nach vorstehendem Anspruch, ferner **gekennzeichnet durch** eine Suppressordiode (103), welche, den Treibermodulen (101, 102) nachgeschaltet ist.

3. Ausgangsschaltung nach vorstehendem Anspruch, **dadurch gekennzeichnet, dass** die Suppressordiode (103) parallel zu einer anschließbaren Last (L) geschaltet ist.

4. Ausgangsschaltung nach einem der vorstehenden Ansprüche, **dadurch gekennzeichnet, dass** jedem der Treibermodule (101, 102) über den einen Peripherieanschluss ein Lastkanal zugewiesen ist.

5. Ausgangsschaltung nach einem der vorstehenden Ansprüche, ferner **gekennzeichnet durch** den Aufbau basierend auf diskreten Bauteilen.

6. Ausgangsschaltung nach einem der vorstehenden Ansprüche, ferner **gekennzeichnet durch** die Integrierung der Treibermodule innerhalb eines gemeinsamen Bauteils (100).

7. Ausgangsschaltung nach vorstehendem Anspruch, ferner **gekennzeichnet durch** die Integrierung einer Suppressordiode innerhalb des gemeinsamen Bauteils (100).

8. Bus-Ausgangsbaugruppe umfassend eine Ausgangsschaltung nach einem der vorstehenden Ansprüche.

9. Bus-Ausgangsbaugruppe nach vorstehendem Anspruch, welche Teil eines Masters, einer sichere Steuerung und/ oder einer Feldeinheit ist.

10. Verwendung einer Ausgangsschaltung nach einem der vorstehenden Ansprüche zum Regeln einer Ausgangsspannung in Abhängigkeit eines bestimmten Impuls-Pausen-Verhältnisses.

11. Verwendung einer Ausgangsschaltung nach vorstehendem Anspruch innerhalb einer Analogausgangsschaltung.

12. Verwendung einer Ausgangsschaltung nach einem der vorstehenden Ansprüche in der Sicherheitstechnik.

13. Verwendung einer Ausgangsschaltung nach einem der vorstehenden Ansprüche zum Schalten eines Aktor-Schutzschaltelements, z.B. eines Relais, Schützes oder Motors.

14. Verfahren zum Testen einer Ausgangsschaltung nach einem der vorstehenden Ansprüche, **dadurch gekennzeichnet, dass** jeder der Treibermodule kurz nacheinander angeschaltet wird und die jeweilige Ausgangsspannung detektiert wird.


## Claims

1. Output circuit having a single-channel peripheral connection for a bus output module to connect an inductive load connected to the peripheral connection,
**characterised by**
at least two driver modules (101, 102), in particular FET transistors, connected in series between a supply voltage ($U_T$) and the peripheral connection (PA).

2. Output circuit as claimed in the preceding Claim, further **characterised by** a suppressor diode (103) which is connected downstream of the driver modules (101, 102).

3. Output circuit as claimed in the preceding Claim, **characterised in that** the suppressor diode (103) is connected in parallel with a connectable load (L).

4. Output circuit as claimed in any one of the preceding Claims, **characterised in that** a load channel is allocated to each of the driver modules (101, 102) via the one peripheral connection.

5. Output circuit as claimed in any one of the preceding Claims, further **characterised by** the design based on separate components.

6. Output circuit as claimed in any one of the preceding Claims, further **characterised by** the integration of the driver modules within a common component (100).

7. Output circuit as claimed in the preceding Claim, further **characterised by** the integration of a suppressor diode within the common component (100).

8. Bus output module including an output circuit as claimed in any one of the preceding Claims.

9. Bus output module as claimed in the preceding Claim, which is part of a master, a secure control system and/or a field unit.

10. Use of an output circuit as claimed in any one of the preceding Claims to control an output voltage in dependence upon a particular impulse/separation ratio.

11. Use of an output circuit as claimed in the preceding Claim within an analogue output circuit.

12. Use of an output circuit as claimed in any one of the preceding Claims in safety engineering.

13. Use of an output circuit as claimed in any one of the preceding Claims for connecting an actuator circuit breaker element, e.g., a relay, a contactor or a motor.

14. Method of testing an output circuit as claimed in any one of the preceding Claims, **characterised in that** each of the driver modules is switched on at short intervals one after the other and the respective output voltage is detected.

**Revendications**

1. Circuit de sortie comprenant un branchement périphérique à un canal pour un ensemble de sortie de bus pour la commutation d'une charge inductive raccordée au branchement périphérique,
**caractérisé par**
au moins deux modules excitateurs (101, 102), en particulier des transistors FET, branchés en série entre une tension d'alimentation ($U_T$) et le branchement périphérique (PA).

2. Circuit de sortie selon la revendication précédente, **caractérisé** également par une diode de suppression (103), qui est montée en aval des modules excitateurs (101, 102).

3. Circuit de sortie selon la revendication précédente, **caractérisé en ce que** la diode de suppression (103) est montée parallèlement à une charge (L) raccordable.

4. Circuit de sortie selon l'une des revendications précédentes, **caractérisé en ce qu'**un canal de charge est attribué à chacun des modules excitateurs (101, 102) par l'intermédiaire d'un branchement périphérique.

5. Circuit de sortie selon l'une des revendications précédentes, **caractérisé** également par la structure sur la base de composants discrets.

6. Circuit de sortie selon l'une des revendications précédentes, **caractérisé** également par l'intégration des modules excitateurs à l'intérieur d'un composant (100) commun.

7. Circuit de sortie selon la revendication précédente, **caractérisé** également par l'intégration d'une diode de suppression à l'intérieur du composant (100) commun.

8. Ensemble de sortie de bus comprenant un circuit de sortie selon l'une des revendications précédentes.

9. Ensemble de sortie de bus selon la revendication précédente, lequel fait partie d'un maître, d'une commande sûre et/ou d'une unité de champ.

10. Utilisation d'un circuit de sortie selon l'une des revendications précédentes pour le réglage d'une tension de sortie en fonction d'un certain rapport des impulsions et des périodes sans impulsion.

11. Utilisation d'un circuit de sortie selon la revendication précédente à l'intérieur d'un circuit de sortie analogique.

12. Utilisation d'un circuit de sortie selon l'une quelconque des revendications précédentes dans la technique de la sécurité.

13. Utilisation d'un circuit de sortie selon l'une quelconque des revendications précédentes pour la commutation d'un élément de commutation de protection d'actionneur, par exemple d'un relais, d'un contacteur ou d'un moteur.

14. Procédé pour tester un circuit de sortie selon l'une quelconque des revendications précédentes, **caractérisé en ce que** chacun des modules excitateurs est successivement enclenché brièvement et la tension de sortie concernée est détectée.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0094238 A